# EUROPÄISCHE PATENTSCHRIFT

(11) **EP 2 477 246 B1**
(45) Veröffentlichungstag und Bekanntmachung des Hinweises auf die Patenterteilung: **15.06.2016**
(21) Anmeldenummer: 12150456.7
(22) Anmeldetag: 09.01.2012
(51) Int. Cl.: H01L 35/26

(54) **Thermoelektrisches Material und Verfahren zur Herstellung**
Thermoelectric material and method for producing same
Matériau thermoélectrique et procédé de fabrication

(30) Priorität: 12.01.2011 DE 102011008377
(43) Veröffentlichungstag der Anmeldung: 18.07.2012
(73) Patentinhaber: Continental Automotive GmbH, 30165 Hannover (DE)
(72) Erfinder: Limbeck, Sigrid, 53804 Much (DE); Brück, Rolf, 51429 Bergisch Gladbach (DE)

(56) Entgegenhaltungen:
- WO-A2-2009/029393
- JP-A- 2004 087 714
- JP-A- 2004 214 244
- JP-A- 2005 197 385
- JP-A- 2005 223 237
- JP-A- 2007 035 857
- US-A- 3 546 026

## Beschreibung

Die vorliegende Erfindung ist auf ein thermoelektrisches Material gerichtet sowie auf ein Verfahren zur Herstellung eines solchen thermoelektrischen Materials. Das thermoelektrische Material wird insbesondere für thermoelektrische Elemente verwendet, die in thermoelektrischen Modulen bzw. thermoelektrischen Generatoren eingesetzt werden können. Diese thermoelektrischen Generatoren werden bevorzugt in Kraftfahrzeugen zur Umwandlung von thermischer in elektrische Energie eingesetzt.

Das Abgas aus einer Verbrennungskraftmaschine eines Kraftfahrzeugs besitzt thermische Energie, welche mittels eines thermoelektrischen Generators in elektrische Energie umgewandelt werden kann, bspw. um eine Batterie oder einen anderen Energiespeicher zu füllen und/oder elektrischen Verbrauchern die benötigte Energie direkt zuzuführen. Damit wird das Kraftfahrzeug mit einem besseren energetischen Wirkungsgrad betrieben, und es steht für den Betrieb des Kraftfahrzeugs Energie in größerem Umfang zur Verfügung.

Ein solcher thermoelektrischer Generator weist zumindest ein thermoelektrisches Modul auf. Thermoelektrische Module umfassen z. B. wenigstens zwei Halbleiterelemente (p-dotiert und n-dotiert), die auf ihrer Oberseite und Unterseite (hin zur Heißseite bzw. Kaltseite) wechselseitig mit elektrisch leitenden Brücken versehen sind, und die die kleinste thermoelektrische Einheit bzw. ein thermoelektrisches Element bilden. Thermoelektrische Materialien sind von einer Art, dass diese effektiv thermische Energie in elektrische Energie umwandeln können (Seebeck-Effekt) und umgekehrt (Peltier-Effekt). Wird ein Temperaturgefälle beidseits der Halbleiterelemente bereitgestellt, so bildet sich zwischen den Enden der Halbleiterelemente ein Spannungspotential aus. Die Ladungsträger auf der heißeren Seite werden durch die höhere Temperatur vermehrt in das Leitungsband angeregt. Durch den dabei erzeugten Konzentrationsunterschied im Leitungsband diffundieren Ladungsträger auf die kältere Seite des Halbleiterelements, wodurch die Potentialdifferenz entsteht. In einem thermoelektrischen Modul sind bevorzugt zahlreiche Halbleiterelemente elektrisch in Reihe geschaltet. Damit sich die generierte Potentialdifferenzen der seriellen Halbleiterelemente nicht gegenseitig aufheben, sind stets wechselweise Halbleiterelemente mit unterschiedlichen Majoritätsladungsträgern (n- und p-dotiert) in direkten elektrischen Kontakt gebracht. Mittels eines angeschlossenen Lastwiderstands kann der Stromkreis geschlossen und somit elektrische Leistung abgegriffen werden.

Um eine dauerhafte Einsatzfähigkeit der Halbleiterelemente zu gewährleisten, wird zwischen den elektrisch leitenden Brücken und dem thermoelektrischen Material regelmäßig eine Diffusionsbarriere angeordnet, die das Diffundieren von in den elektrischen Brücken bzw. im Lot enthaltenem Material in das thermoelektrische Material verhindert. Somit wird auch ein Effektivitätsverlust bzw. ein funktionelles Versagen des Halbleitermaterials bzw. des thermoelektrischen Elements verhindert.

Der Aufbau von thermoelektrischen Modulen bzw. der Halbleiterelemente erfolgt üblicherweise durch den Zusammenbau der einzelnen Komponenten: thermoelektrisches Material, Diffusionsbarriere, elektrisch leitende Brücken, Isolierung und ggf. weiteren Gehäuseelementen. Das thermoelektrische Modul wird von einem heißen bzw. kalten Medium überströmt. Dieser Zusammenbau zahlreicher einzelner Komponenten erfordert auch eine genaue Abstimmung der einzelnen Bauteiltoleranzen und eine Berücksichtigung der Wärmeübergänge von der Heißseite zur Kaltseite sowie der hinreichenden Kontaktierung der elektrisch leitenden Brücken, so dass ein Stromfluss durch das thermoelektrische Modul erzeugt werden kann.

Für die Anordnung solcher Halbleiterelemente in einem thermoelektrischen Modul sind regelmäßige Gehäuse, Wände und/oder Stützrohre zur äußeren Begrenzung des Moduls vorgesehen, zwischen denen die Halbleiterelemente befestigt sind. Dies führt insbesondere dazu, dass bei der Fertigung hohe Toleranzanforderungen gegeben sind, um eine passgenaue Anordnung der Halbleiterelemente mit Bezug auf die elektrischen Verbindungen sowie die Position der Gehäuse zu realisieren. Problematisch ist darüber hinaus, dass in Folge der unterschiedlichen thermischen Belastungen der äußeren und inneren Gehäuseteile bei rohrförmigen thermoelektrischen Modulen auch unterschiedliche Ausdehnungsverhalten dieser Komponenten berücksichtigt werden müssen. Hier entstehen hohe Spannungen innerhalb des thermoelektrischen Materials, die zum Versagen des thermoelektrischen Materials und damit des thermoelektrischen Moduls führen können. Insbesondere vor dem Hintergrund, dass die einzelnen thermoelektrischen Elemente üblicherweise elektrisch in Reihe geschaltet werden, ist das Versagen bereits eines thermoelektrischen Elements gleichzusetzen mit einem Totalausfall eines thermoelektrischen Moduls. Gerade im Hinblick auf rohrförmige thermoelektrische Module mit ring- oder ringsegmentförmigen thermoelektrischen Elementen ist es gewünscht, dass auch bei starken Temperaturgradienten und entsprechend unterschiedlichem Ausdehnungsverhalten nicht nur des thermoelektrischen Materials sondern auch anderer Komponenten des thermoelektrischen Moduls eine ausreichende Dauerfestigkeit gewährleistet werden kann.

Aus der WO 2009/029393 A2 und JP 2004-087714 A sind Anordnungen von Fasern in einer Matrix bekannt, wobei die Fasern zur gezielten Weiterleitung der Elektronen durch das thermoelektrische Materials über die Fasern selbst eingesetzt werden.

Die US 3,546,026 A, JP 2005-223237 A, JP 2004-214244 A und JP 2007-035857 A sind jeweils auf thermoelektrische Materialien gerichtet, die durch den Einsatz von Fasern in ihren mechanischen Eigenschaften verstärkt werden. Dabei wird vorgeschlagen, dass die Fasern gleichmäßig verteilt in der Matrix aus thermoelektrischem Material anzuordnen sind. JP 2005-197385 A ist auf die Herstellung eines rohrförmigen thermoelektrischen Moduls gerichtet.

Hiervon ausgehend ist es Aufgabe der vorliegenden Erfindung, die im Zusammenhang mit dem Stand der Technik geschilderten Probleme zumindest teilweise zu lösen. Insbesondere soll ein thermoelektrisches Materials angegeben werden, das für den gewünschten Einsatz in rohrförmigen thermoelektrischen Modulen dauerfest ausgeführt ist und gleichzeitig einen hohen Wirkungsgrad aufweist, um aus der thermischen Energie eines Abgases oder eines anderen heißen Mediums elektrische Energie zu erzeugen.

Diese Aufgaben werden gelöst mit einem thermoelektrischen Material gemäß den Merkmalen des Patentanspruchs 1 und durch ein Verfahren zur Herstellung eines thermoelektrischen Materials gemäß den Merkmalen des Patentanspruchs 12. Weitere vorteilhafte Ausgestaltungen der Erfindung sind in den abhängig formulierten Patentansprüchen angegeben. Die in den Patentansprüchen einzeln aufgeführten Merkmale sind in beliebiger, technologisch sinnvoller, Weise miteinander kombinierbar und zeigen weitere Ausgestaltungen der Erfindung auf. Die Beschreibung, insbesondere im Zusammenhang mit den Figuren, erläutert die Erfindung weiter und führt ergänzende Ausführungsbeispiele der Erfindung an.

Das erfindungsgemäße thermoelektrische Material umfasst eine erste Seite und eine gegenüberliegend angeordnete zweite Seite und enthält Fasern.

Insbesondere ist die erste Seite oder zweite Seite einer Heißseite oder einer Kaltseite in einem thermoelektrischen Modul zugeordnet, so dass ein Wärmestrom das thermoelektrische Material von der ersten Seite hin zur zweiten Seite (oder umgekehrt) durchströmt.

Grundsätzlich ist die Form des thermoelektrischen Materials z. B. unter Berücksichtigung der Integration in ein thermoelektrisches Modul wählbar. Das thermoelektrische Material kann insbesondere in verschiedene Formen gepresst und/oder gedruckt werden. Somit kann das thermoelektrische Material beispielsweise nach Art eines Quaders, Blockes, Steifens oder dergleichen bereitgestellt sein.

Gemäß einer bevorzugten Ausgestaltung ist das thermoelektrische Material ringförmig oder ringsegmentförmig, wobei die erste Seite eine Innenumfangsfläche des thermoelektrischen Materials und die zweite Seite eine Außenumfangsfläche des thermoelektrischen Materials bildet.

Das thermoelektrische Material wird entsprechend zumindest aus Halbleitermaterial und Fasern gebildet. Durch die gemeinsame Anordnung von Fasern und Halbleitermaterial zu einem thermoelektrischen Material wird insbesondere ein (Faser-)Verbundwerkstoff erzeugt, der andere Werkstoffeigenschaften aufweist als seine einzelnen Komponenten.

Als Fasern können Keramikfasern, Glasfasern, metallische Fasern und/oder Kohlefasern eingesetzt werden. Die Fasern erfüllen hierbei insbesondere die Funktion, eine thermische Leitfähigkeit, elektrische Leitfähigkeit, eine Zugfestigkeit und/oder eine Dehnbarkeit des thermoelektrischen Materials zu beeinflussen bzw. einzustellen.

Besonders bevorzugt sind hierbei Keramikfasern. Als Keramikfasern werden insbesondere nichtoxidische und/oder oxidische Keramiken eingesetzt. Oxidische Keramikfasern können insbesondere mit folgenden Materialen gebildet werden: Aluminiumoxid, Zirconiumoxid, Titan(IV)-oxid, Magnesiumoxid, Zinkoxid, Aluminiumtitanat, Bariumtitanat.

Aufgrund der Anfälligkeit gegenüber Temperaturwechselbeanspruchung werden die oxidischen Keramikfasern hier insbesondere in dem thermoelektrischen Material im Bereich der Kaltseite eingesetzt. "Im Bereich der Kaltseite" bedeutet insbesondere, dass diese Keramikfasern zumindest zu 80 Gew.-% des Gesamtanteils dieser Keramikfaser im thermoelektrischen Material in einem an der Kaltseite angeordneten Abschnitt des thermoelektrischen Materials angeordnet sind, der höchstens ein Drittel des Abstands von erster Seite zu zweiter Seite des thermoelektrischen Materials umfasst. Bevorzugt sind diese oxidischen Keramikfasern quer zum Wärmestrom durch das thermoelektrische Material angeordnet, so dass die Kermikfaser selbst eine möglichst gleiche Temperatur über ihre Erstreckung aufweist.

Nichtoxidische Keramikfasern können insbesondere mit folgenden Materialien gebildet werden: Siliziumnitrid, Borcarbid, Bornitrid, Siliziumcarbid, Aluminiumnitrid. Die nichtoxidischen Keramikfasern weisen im Vergleich zu oxidischen Keramikfasern üblicherweise eine höhere Wärmeleitfähigkeit auf. Insbesondere können daher diese nichtoxidischen Keramikfasern nur zu geringen Anteilen in Richtung des Wärmestroms innerhalb des thermoelektrischen Materials angeordnet werden.

Insbesondere werden Mischungen dieser Keramiken verwendet und entsprechend als Keramikfasern hier eingesetzt.

Insbesondere ist das thermoelektrische Material ein gesinterter Werkstoff, wobei die Keramikfasern in dem thermoelektrischen Material bereits vor dem Sintern enthalten sind und infolge des Sinterns fest mit dem thermoelektrischen Material verbunden werden. Als Halbleitermaterial für das thermoelektrische Material kommt bevorzugt zumindest eines der folgenden Materialien zum Einsatz, ggf. auch Mischformen (in Klammern: bevorzugte maximale Einsatztemperatur):
n-Typ:
   Bi₂Te₃ [ca. 250 °C]; PbTe [ca. 500 °C]; Ba_{0,3}Co_{3,95}Ni_{0,05}Sb₁₂ [ca. 600 °C]; Ba_{y}(Co,Ni)₄Sb₁₂ [ca. 600 °C]; CoSb₃ [ca. 700 °C]; Ba₈Ga₁₆Ge₃₀ [ca. 850 °C]; La₂Te₃[ca. 1100 °C]; SiGe [ca. 1000 °C]; Mg₂(Si,Sn) [ca. 700 °C];
p-Typ:
   (Bi,Sb)₂Te₃ [ca. 200 °C]; Zn₄Sb₃ [ca. 380 °C]; TAGS [ca. 600 °C]; PbTe [ca. 500 °C]; SnTe [ca. 600 °C]; CeFe₄Sb₁₂ [ca. 700 °C]; Yb₁₄MnSb₁₁ [ca. 1000 °C]; SiGe [ca. 1000 °C]; Mg₂(Si,Sb) [ca. 600 °C].

Gerade bei ringförmigem oder ringsegmentförmigem thermoelektrischem Material kommt es aufgrund der rohrförmigen Ausgestaltung des thermoelektrischen Moduls, in dem die thermoelektrischen Materialien als thermoelektrische Elemente angeordnet sind, im besonderen Maße auch innerhalb des thermoelektrischen Materials zu Spannungen. Diese Spannungen werden durch die in rohrförmigen thermoelektrischen Modulen schwierig zu kompensierende thermische Ausdehnung z. B. eines Innenrohrs oder eines Außenrohrs hervorgerufen. Dieser Effekt wird zusätzlich dadurch verstärkt, dass gerade auf der Außenumfangsfläche an verschiedenen Positionen unterschiedliche Temperaturen vorliegen können, so dass auch hier unterschiedliche thermische Spannungen hervorgerufen werden können. Da gerade ringförmige thermoelektrische Materialien über eine große Außenumfangsfläche verfügen bzw. auch bei angepasster Dicke in Umfangsrichtung gesehen zumindest eine große Erstreckung aufweisen, sind sie besonders stark von diesen thermischen Spannungen betroffen. Zur Stabilisierung des thermoelektrischen Materials wird also vorgeschlagen, Keramikfasern in das thermoelektrische Material einzubringen, so dass das thermoelektrische Material eine vergleichsweise höhere Zugfestigkeit (Rₘ in N/mm² [Newton pro Quadratmillimeter]) und/oder eine höhere Streckgrenze (R_{p0,2} in N/mm²) und damit insbesondere eine bessere Temperaturwechselbeständigkeit aufweist.

Gemäß einer besonders bevorzugten Ausgestaltung sind zumindest 80 Gew.-% der Fasern parallel zueinander angeordnet. Insbesondere sind diese Fasern so orientiert, dass sie sich im Wesentlichen von der Innenumfangsfläche hin zur Außenumfangsfläche erstrecken, also parallel zu einer radialen Richtung orientiert sind. Infolge dieser Orientierung stellen die Fasern auch keine Barriere für die Ladungsträger dar, so dass das thermoelektrische Material durch die Fasern keine schlechtere Effizienz hinsichtlich der Erzeugung elektrischer Energie aufweist.

Insbesondere sind Fasern mit unterschiedlicher Orientierung (Ausrichtung bzw. Lage) innerhalb des thermoelektrischen Materials vorgesehen. Insbesondere weisen die Fasern zwei unterschiedliche Orientierungen auf, bevorzugt drei unterschiedliche Orientierungen. Insbesondere sind zumindest 80 Gew.-% der Fasern im Wesentlichen parallel zu jeweils einer der unterschiedlichen Orientierungen ausgerichtet. Die Fasern sind insbesondere mit zwei oder drei unterschiedliche Orientierungen im thermoelektrischen Material angeordnet und zumindest 80 Gew.-% der Fasern sind parallel zu einer der Orientierungen ausgerichtet. Insbesondere umfassen diese unterschiedlichen Orientierungen eine Orientierung in radialer Richtung, eine Orientierung in Umfangsrichtung und eine Orientierung in Richtung der Dicke des thermoelektrischen Materials. dass zumindest 80 Gew.-% der Fasern sich ausgehend von der Innenumfangsfläche bzw. Außenumfangsfläche eines ringförmigen oder ringsegmentförmigen thermoelektrischen Materials jeweils in radialer Richtung erstrecken. Gerade hier ist dabei insbesondere vorgesehen, dass Fasern, die in radialer Richtung angeordnet sind, das heißt, die in Richtung der Verbindung von Kaltseite zu Heißseite orientiert sind, eine geringere elektrische Leitfähigkeit als das Halbleitermaterial aufweisen, so dass die Elektronen nicht über die Fasern geleitet werden, sondern sich innerhalb des Halbleitermaterials bewegen.

Insbesondere sind die Fasern zur Stabilisierung des thermoelektrischen Materials vorgesehen. Die (/alle) Fasern weisen bevorzugt eine elektrische Leitfähigkeit [Ampere/(Volt * Meter)] auf, die geringer ist als die elektrische Leitfähigkeit des Halbleitermaterials. Insbesondere trifft dies für mindestens 80 Gew.-% der Fasern zu. Bevorzugt beträgt die elektrische Leitfähigkeit der Fasern in einem Temperaturbereich zwischen 20 °C und 250 °C [Grad Celsius] höchstens 50 % und besonders bevorzugt höchstens 20 % und insbesondere höchstens 5 % der elektrischen Leitfähigkeit des Halbleitermaterials.

Insbesondere ist die (spezifische) Wärmeleitfähigkeit der (/aller) Fasern geringer als die des Halbleitermaterials. Insbesondere trifft dies für mindestens 80 Gew.-% der Fasern zu. Die spezifische Wärmeleitfähigkeit [Watt/(Kelvin * Meter)] ist die Fähigkeit eines Stoffes, thermische Energie mittels Wärmeleitung in Form von Wärme zu transportieren. Bevorzugt beträgt die Wärmeleitfähigkeit der Fasern in einem Temperaturbereich zwischen 20 °C und 250 °C [Grad Celsius] höchstens 50 % und besonders bevorzugt höchstens 20 % und insbesondere höchstens 5 % der Wärmeleitfähigkeit des Halbleitermaterials.

Gemäß einer bevorzugten Weiterbildung des thermoelektrischen Materials sind die Fasern ungleichmäßig im thermoelektrischen Material verteilt. Das heißt insbesondere, dass bei ringförmigen oder ringsegmentförmigen thermoelektrischen Materialien zumindest 50 Gew.-% der Fasern in einem Erfindungsgemäß sind zumindest 80 Gew.-% der Fasern quer zu zumindest der ersten Seite oder der zweiten Seite ausgerichtet. Das heißt insbesondere, dass zumindest 80 Gew.-% der Fasern sich ausgehend von der Innenumfangsfläche bzw. Außenumfangsfläche eines ringförmigen oder ringsegmentförmigen thermoelektrischen Materials jeweils in radialer Richtung erstrecken. Gerade hier ist dabei insbesondere vorgesehen, dass Fasern, die in radialer Richtung angeordnet sind, das heißt, die in Richtung der Verbindung von Kaltseite zu Heißseite orientiert sind, eine geringere elektrische Leitfähigkeit als das Halbleitermaterial aufweisen, so dass die Elektronen nicht über die Fasern geleitet werden, sondern sich innerhalb des Halbleitermaterials bewegen.

Insbesondere sind die Fasern zur Stabilisierung des thermoelektrischen Materials vorgesehen. Die (/alle) Fasern weisen erfindungsgemäß eine elektrische Leitfähigkeit [Ampere/(Volt * Meter)] auf, die geringer ist als die elektrische Leitfähigkeit des Halbleitermaterials. Insbesondere trifft dies für mindestens 80 Gew.-% der Fasern zu. Bevorzugt beträgt die elektrische Leitfähigkeit der Fasern in einem Temperaturbereich zwischen 20 °C und 250 °C [Grad Celsius] höchstens 50 % und besonders bevorzugt höchstens 20 % und insbesondere höchstens 5 % der elektrischen Leitfähigkeit des Halbleitermaterials.

Insbesondere ist die (spezifische) Wärmeleitfähigkeit der (/aller) Fasern geringer als die des Halbleitermaterials. Insbesondere trifft dies für mindestens 80 Gew.-% der Fasern zu. Die spezifische Wärmeleitfähigkeit [Watt/(Kelvin * Meter)] ist die Fähigkeit eines Stoffes, thermische Energie mittels Wärmeleitung in Form von Wärme zu transportieren. Bevorzugt beträgt die Wärmeleitfähigkeit der Fasern in einem Temperaturbereich zwischen 20 °C und 250 °C [Grad Celsius] höchstens 50 % und besonders bevorzugt höchstens 20 % und insbesondere höchstens 5 % der Wärmeleitfähigkeit des Halbleitermaterials.

Gemäß einer bevorzugten Weiterbildung des thermoelektrischen Materials sind die Fasern ungleichmäßig im thermoelektrischen Material verteilt. Das heißt insbesondere, dass bei ringförmigen oder ringsegmentförmigen thermoelektrischen Materialien zumindest 50 Gew.-% der Fasern in einem Bereich in radialer Richtung des thermoelektrischen Materials angeordnet sind, der sich ausgehend von der Außenumfangsfläche über ein Drittel des Abstands zwischen erster Seite und zweiter Seite des thermoelektrischen Materials erstreckt. Insbesondere sind die Fasern ausschließlich in radialer Richtung ungleichmäßig verteilt, das heißt, dass die thermoelektrischen Materialien insbesondere unabhängig von ihrer Lage, sondern allein vorgegeben durch ihre geometrische Form, unverwechselbar eingebaut werden können.

Gemäß einer weiteren besonders vorteilhaften Ausgestaltung sind die Fasern mit mindestens einer voneinander verschiedenen Eigenschaft ausgeführt, wobei die Eigenschaft eine der folgenden ist: thermische Leitfähigkeit (in Watt pro Kelvin [W/K], elektrische Leitfähigkeit (in Ampere pro Volt*Meter [W/(V*m)], Zugfestigkeit (s.o.), Dehnbarkeit (Längenänderung einer Zugprobe bis zum Bruch), Streckgrenze (s.o.), Bruchdehnung (bleibende Verlängerung einer Zugprobe nach dem Bruch, bezogen auf die Anfangslänge der Zugprobe). Insbesondere sind die Fasern mit voneinander verschiedenen Eigenschaften zu gleichen oder unterschiedlichen Anteilen in einer gemeinsamen Orientierung angeordnet. Es ist aber auch möglich, gezielt Eigenschaften des thermoelektrischen Materials dadurch zu beeinflussen, dass Fasern mit jeweils gleichen Eigenschaften gleiche Orientierungen aufweisen und entsprechend Fasern mit anderen Eigenschaften in einer anderen Orientierung in dem thermoelektrischen Material angeordnet sind.

Gemäß einer weiteren vorteilhaften Ausgestaltung sind die Fasern zumindest mittels Formschluss oder Adhäsion mit dem thermoelektrischen Material verbunden. Unter Formschluss wird hier verstanden, dass einer der Verbindungspartner dem anderen im Weg ist. Der Formschluss stellt sich insbesondere dadurch ein, dass die Fasern nicht vollständig gerade sind, sondern zumindest teilweise gekrümmt sind oder andere Formabweichungen aufweisen. Insbesondere weisen die Fasern eine Oberfläche mit einer gemittelten Rautiefe Rz von zumindest 0,5 µm auf, so dass eine bessere Anbindung zwischen thermoelektrischem Material und Fasern erreicht wird.

Bevorzugt sind die Fasern auch kraftschlüssig und insbesondere auch stoffschlüssig mit dem Halbleitermaterial verbunden. Kraftschlüssig heißt hier insbesondere, dass die gegenseitige Verschiebung der Verbindungspartner (Faser, Halbleitermaterial) verhindert wird, solange die durch die Haftreibung bewirkte Gegen-Kraft nicht überschritten wird. Stoffschlüssig heißt hier, dass die Verbindungspartner durch atomare oder molekulare Kräfte zusammengehalten werden.

Gemäß einer weiteren vorteilhaften Weiterbildung haben die Fasern zusammen einen Anteil von höchstens 70 Gew.-% gemessen am Gesamtgewicht des thermoelektrischen Materials. Insbesondere haben die Fasern einen Anteil von mindestens 30 Gew.- % am Gesamtgewicht des thermoelektrischen Materials. Durch diesen hohen Anteil an Fasern (mit geringerer elektrischer Leitfähigkeit als das Halbleitermaterial) wird einerseits die Eigenschaft des thermoelektrischen Materials hinsichtlich der Energieumwandlung nicht wesentlich verschlechtert, gleichzeitig aber eine thermische Isolierung zwischen einer Heißseite und einer Kaltseite eines thermoelektrischen Moduls (durch Fasern mit geringerer Wärmeleitfähigkeit als das Halbleitermaterial) verbessert. Die mechanischen Eigenschaften des thermoelektrischen Materials sind deutlich verbessert.

Bevorzugt haben die Fasern einen Anteil von höchstens 30 Gew.-%, besonders bevorzugt einen Anteil von höchstens 5 Gew.-% gemessen am Gesamtgewicht des thermoelektrischen Materials. Bereits durch einen geringeren Faseranteil (von höchstens 30 Gew.-%) können die mechanischen Eigenschaften deutlich verbessert werden, so dass das thermoelektrische Material z. B. eine höhere Dauerfestigkeit aufweist.

Gemäß einer weiteren vorteilhaften Ausgestaltung weisen die Fasern zumindest teilweise eine Beschichtung auf. Die Beschichtung weist insbesondere Whisker auf, die sich im Wesentlichen quer zu der Erstreckung der Faser hin zum thermoelektrischen Material erstrecken. Durch diese Whisker wird zusätzlich eine verbesserte Haftung bzw. ein Formschluss zwischen thermoelektrischem Material und Faser erreicht. Weiterhin kann die Beschichtung aber z. B. auch eine elektrisch isolierende Beschichtung sein, so dass auch elektrisch leitende Fasern innerhalb des thermoelektrischen Materials auch in einer radialen Richtung eingesetzt werden können.

Die Erfindung ist weiterhin auf ein Verfahren zur Herstellung eines thermoelektrischen Materials gerichtet, wobei das Verfahren zumindest die folgenden Schritte umfasst:
a) Bereitstellen eines pulverförmigen Halbleitermaterials,
b) Bereitstellen von Fasern, die eine geringere elektrische Leitfähigkeit als das Halbleitermaterial aufweisen.
c) Anordnen der Fasern zusammen mit dem Halbleitermaterial zu einem Ausgangsmaterial,
d) Verpressen des Ausgangsmaterials
wobei zumindest 80 Gew.-% der Fasern quer zu zumindest der ersten Seite oder der zweiten Seite ausgerichtet sind.

Somit wird insbesondere ein erfindungsgemäßes thermoelektrisches Material mit Fasern hergestellt. Das Verpressen des Ausgangsmaterials erfolgt insbesondere unter Überdruck und gleichzeitig einer Temperatur von mindestens 250 °C. Durch dieses Verfahren wird das thermoelektrische Material gesintert, so dass sich eine besonders dichte Materialmischung erzeugen lässt und die Fasern möglichst fest innerhalb des thermoelektrischen Materials angeordnet sind. Der Überdruck beträgt hier zwischen 0 und 100 Megapascal (MPa), bevorzugt kleiner 1 MPa, besonders bevorzugt kleiner 0,5 MPa.

Gemäß einer besonders vorteilhaften Ausgestaltung sind die bereitgestellten Fasern zuvor wenigstens teilweise beschichtet worden. Dies gilt in besonderem Maße für den Fall, dass Keramikfasern eingesetzt werden.

Es wird hier darauf hingewiesen, dass die im Zusammenhang mit dem thermoelektrischen Material beschriebenen Ausgestaltungen gleichermaßen für das erfindungsgemäße Verfahren Anwendung finden und umgekehrt.

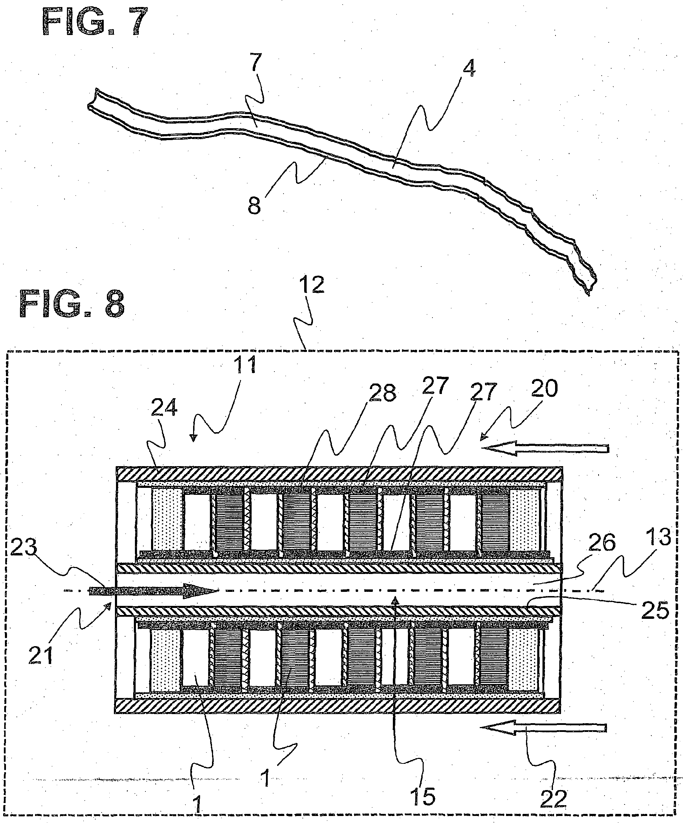

Die Erfindung findet insbesondere Anwendung bei einem Kraftfahrzeug mit einer Verbrennungskraftmaschine mit einem Abgassystem, wobei ein thermoelektrischer Generator vorgesehen ist, der mit dem Abgassystem so zusammenwirkt, dass er thermische Energie des Abgases (mittelbar oder unmittelbar) aufnimmt und mittels einem thermoelektrischen Material der erfindungsgemäßen Art, bzw. hergestellt nach dem obigen Verfahren, in elektrische Energie umwandelt. In diesem Zusammenhang wird insbesondere auch auf die Erläuterungen zu Fig. 8 verwiesen.

Die Erfindung wird nachfolgend anhand der Figuren näher erläutert. Es ist darauf hinzuweisen, dass die in den Figuren gezeigten Ausführungsbeispiele bevorzugt sind, die Erfindung jedoch nicht darauf beschränkt ist. Die Figuren zeigen schematisch:
- Fig. 1:: ein ringförmiges thermoelektrisches Material im Schnitt in einer Draufsicht,
- Fig. 2:: thermoelektrisches Material nach Fig. 1 im Schnitt in einer Seitenansicht,
- Fig. 3:: Verfahrensschritt a),
- Fig. 4:: Verfahrensschritt b),
- Fig. 5:: Verfahrensschritt c),
- Fig. 6:: Verfahrensschritt d),
- Fig. 7:: eine beschichtete Keramikfaser, und
- Fig. 8:: ein Kraftfahrzeug mit einem thermoelektrischen Generator.

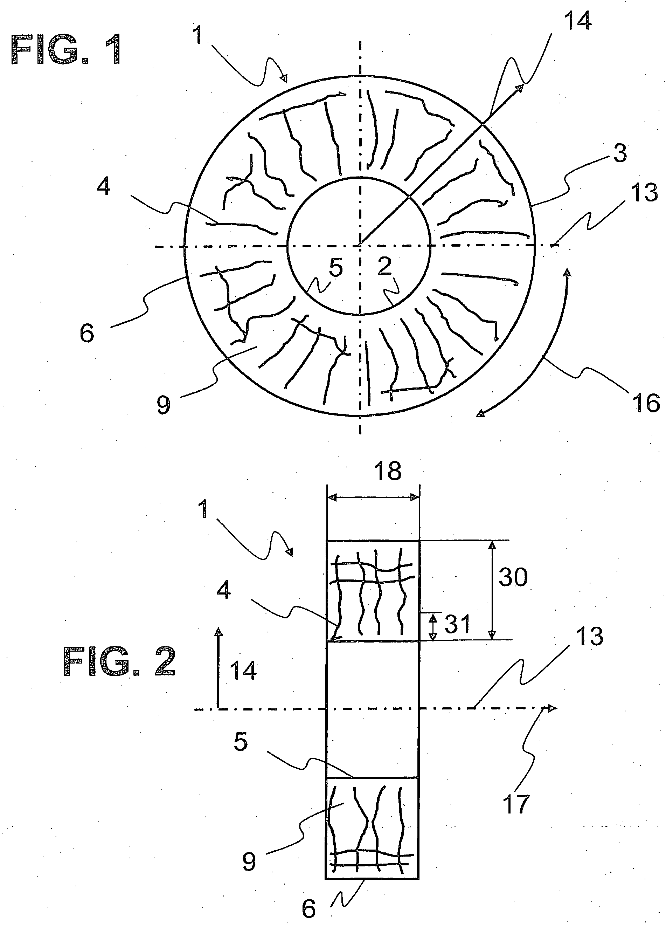

Fig. 1 zeigt in einer Draufsicht ein ringförmiges thermoelektrisches Material 1. Das ringförmige thermoelektrische Material 1 ist in einer Schnittdarstellung dargestellt, so dass die Fasern 4 im Inneren des thermoelektrischen Materials 1 dargestellt werden können. Das thermoelektrische Material 1 weist eine Außenumfangsfläche 6 als zweite Seite 3 und eine Innenumfangsfläche 5 als gegenüberliegend angeordnete erste Seite 2 auf. Die gezeigten Fasern 4 erstrecken sich im Wesentlichen in der radialen Richtung 14 von der Innenumfangsfläche 5 hin zur Außenumfangsfläche 6. Da die Fasern 4 keine gradlinige bzw. gestreckte Erstreckung aufweisen müssen, soll hier noch einmal verdeutlich werden, dass eine erfindungsgemäße Anordnung der Fasern 4 immer eine geringe Ungenauigkeit aufweist. Einzelne Fasern 4 sind hier auch in Umfangsrichtung 16 angeordnet. Die Fasern 4 sind innerhalb des Halbleitermaterials 9 angeordnet und formschlüssig und/oder durch Adhäsion mit dem Halbleitermaterial 9 verbunden. Formschlüssig bedeutet hier, dass einer der Verbindungspartner (Faser 4, Halbleitermaterial 9) dem jeweils anderen im Weg ist. Dabei kann infolge des Herstellungsprozesses auch (zusätzlich) eine kraftschlüssige und/oder stoffschlüssige Verbindung hergestellt sein zwischen Faser 4 und Halbleitermaterial 9. Kraftschlüssig bedeutet hier, dass die gegenseitige Verschiebung der Verbindungspartner Faser 4 und Halbleitermaterial 9 verhindert wird, solange die durch die Haftreibung bewirkte Gegenkraft nicht überschritten wird. Stoffschlüssig bedeutet hier, dass die Verbindungspartner (Faser 4 und Halbleitermaterial 9) durch atomare oder molekulare Kräfte zusammengehalten werden. Dadurch werden nicht lösbare Verbindungen geschaffen, die sich nur durch Zerstörung der Verbindungsmittel trennen lassen. Dies kann insbesondere dadurch erzeugt werden, dass infolge eines Sinter- bzw. Heißsinterprozesses das Halbleitermaterial 9 und die Fasern 4 zumindest teilweise z. B. infolge Diffusion sich miteinander verbinden, so dass eine stoffschlüssige Verbindung zumindest teilweise realisiert wird.

Das thermoelektrische Material 1 ist hier nur in Ringform dargestellt. Es wird ausdrücklich darauf hingewiesen, dass die Ausführungsbeispiele sich entsprechend auf ringsegmentförmige oder auch quaderförmige thermoelektrische Materialien 1 übertragen lassen.

Fig. 2 zeigt das thermoelektrische Material 1 gemäß Fig. 1 in einer Seitendarstellung, wobei hier ebenfalls das thermoelektrische Material 1 im Schnitt dargestellt wird. Das thermoelektrische Material 1 erstreckt sich in der axialen Richtung 17 über eine Dicke 18. Das thermoelektrische Material 1 wird gebildet durch Halbleitermaterial 9 und Fasern 4, die sich hier im Wesentlichen in radialer Richtung 14 von der Innenumfangsfläche 5 hin zur Außenumfangsfläche 6 erstrecken. Weitere Fasern 4 erstrecken sich in Richtung der axialen Richtung 17. Innenumfangsfläche 5 und Außenumfangsfläche 6 weisen einen Abstand 30 voneinander auf. Ein Abschnitt 31 des Abstands 30 erstreckt sich in Umfangsrichtung 16 um die Innenumfangsfläche 5.

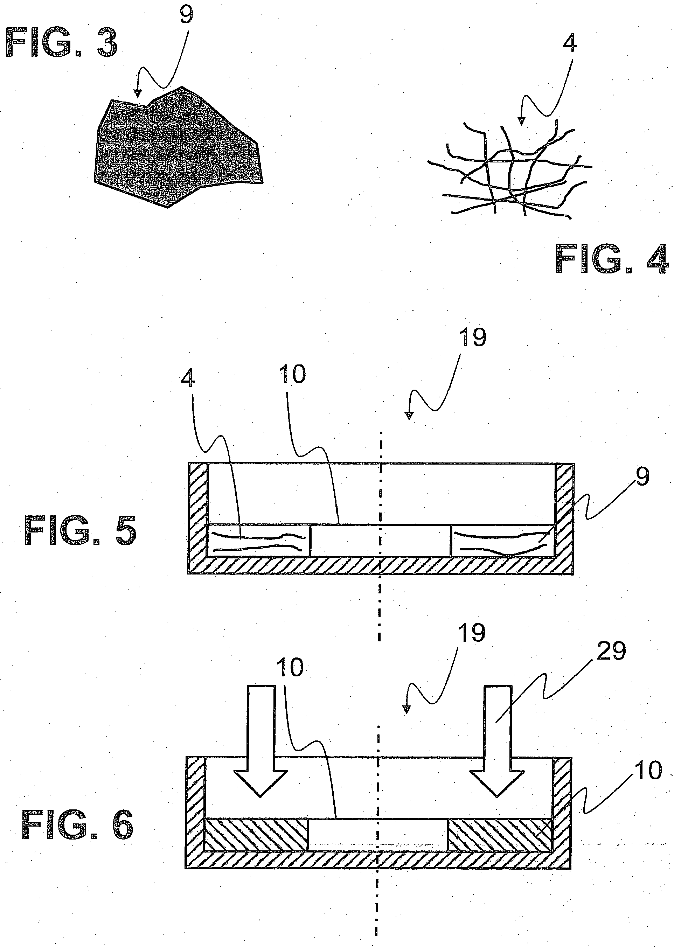

Fig. 3 zeigt den Verfahrensschritt a) des erfindungsgemäßen Verfahrens, wobei hier ein pulverförmiges Halbleitermaterial 9 bereitgestellt wird.

Fig. 4 zeigt Verfahrensschritt b) des erfindungsgemäßen Verfahrens, wobei hier Fasern 4, gegebenenfalls hinsichtlich ihrer Eigenschaften separat oder entsprechend gemischt, bereitgestellt werden.

Fig. 5 zeigt den Verfahrensschritt c) des erfindungsgemäßen Verfahrens, wobei die Fasern 4 zusammen mit dem Halbleitermaterial 9 zu einem Ausgangsmaterial 10 gemischt und/oder angeordnet werden. Hier erfolgt bereits die konkrete Ausrichtung der einzelnen Fasern 4. Das Ausgangsmaterial 10 wird in einer Form 19 angeordnet.

Fig. 6 zeigt Verfahrensschritt d) des erfindungsgemäßen Verfahrens, wobei das Ausgangsmaterial 10 in der Form 19 durch Beaufschlagen mit einem Druck 29 verpresst wird. Dieses Verpressen bewirkt insbesondere einen Sinterprozess, wobei dieser insbesondere unter gleichzeitiger Beaufschlagung mit einer erhöhten Temperatur von mindestens 250 °C erfolgt, so dass ein Heißsinterprozess erfolgt.

Fig. 7 zeigt eine Faser 4, die zumindest teilweise eine Beschichtung 8 aufweist. Die Faser 4 weist mehrere Eigenschaften 7 auf, wobei sich mehrere Fasern 4 hinsichtlich zumindest einer Eigenschaft 7 unterscheiden können. Diese Eigenschaften 7 sind z. B. thermische Leitfähigkeit, elektrische Leitfähigkeit, Zugfestigkeit, Dehnbarkeit, Bruchdehnung, Rauigkeit, Streckgrenze.

Fig. 8 zeigt schematisch ein Kraftfahrzeug 12 mit einem thermoelektrischen Generator 11. Der thermoelektrische Generator 11 ist rohrförmig aufgebaut und weist zwischen einem Außenrohr 24 und einem Innenrohr 25 ringförmige thermoelektrische Materialien 1 auf, die wechselweise über ihre Außenumfangsfläche bzw. Innenumfangsfläche über elektrisch leitende Brücken 27 elektrisch leitend miteinander verbunden sind. Der thermoelektrische Generator 11 weist an seinem Außenrohr 24 eine Heißseite 20 und an seinem Innenrohr 25 eine Kaltseite 21 auf. Die Kaltseite 21 wird gebildet durch einen Kanal 26 innerhalb des Innenrohrs 25, der sich entlang der Mittelachse 13 erstreckt. Der Kanal 26 wird dabei von einem Kühlmedium 23 durchströmt. Die Heißseite 20 wird von einem Abgas 22 oder einem anderen heißen Medium überströmt. Entsprechend werden die thermoelektrischen Materialien 1 von einem Wärmestrom 15 von der Heißseite 20 hin zur Kaltseite 21 durchströmt. Weiterhin weist der thermoelektrische Generator 11 eine elektrische Isolierung zwischen den elektrisch leitenden Brücken 27 und dem Außenrohr 24 bzw. und dem Innenrohr 25 auf. Die Heißseite 20 kann entsprechend auch an dem Innenrohr 25 angeordnet sein.

### Bezugszeichenliste

- 1: Thermoelektrisches Material
- 2: Erste Seite
- 3: Zweite Seite
- 4: Faser
- 5: Innenumfangsfläche
- 6: Außenumfangsfläche
- 7: Eigenschaft
- 8: Beschichtung
- 9: Halbleitermaterial
- 10: Ausgangsmaterial
- 11: Thermoelektrischer Generator
- 12: Kraftfahrzeug
- 13: Mittelachse
- 14: Radiale Richtung
- 15: Wärmestrom
- 16: Umfangsrichtung
- 17: Axiale Richtung
- 18: Dicke
- 19: Form
- 20: Heißseite
- 21: Kaltseite
- 22: Abgas
- 23: Kühlmedium
- 24: Außenrohr
- 25: Innenrohr
- 26: Kanal
- 27: Brücke
- 28: Isolierung
- 29: Druck
- 30: Abstand
- 31: Abschnitt

## Patentansprüche

1. Thermoelektrisches Material (1) mit einer ersten Seite (2) und einer gegenüberliegend angeordneten zweiten Seite (3), wobei das thermoelektrische Material (1) Fasern (4) enthält, wobei zumindest 80 Gew.-% der Fasern (4) quer zu zumindest der ersten Seite (2) oder der zweiten Seite (3) ausgerichtet sind und wobei die Fasern (4) eine geringere elektrische Leitfähigkeit als das Halbleitermaterial (9) aufweisen.

2. Thermoelektrisches Material (1) gemäß Patentanspruch 1, wobei das thermoelektrische Material (1) ringförmig oder ringsegmentförmig ist, wobei die erste Seite (2) eine Innenumfangsfläche (5) des thermoelektrischen Materials (1) und die zweite Seite (3) eine Außenumfangsfläche (6) des thermoelektrischen Materials (1) bildet.

3. Thermoelektrisches Material (1) gemäß Patentanspruch 1 oder 2, wobei zumindest 80 Gew.-% der Fasern (4) parallel zueinander angeordnet sind.

4. Thermoelektrisches Material (1) gemäß einem der vorhergehenden Patentansprüche, wobei Fasern (4) mit zwei oder drei unterschiedliche Orientierungen im thermoelektrischen Material (1) angeordnet sind, und zumindest 80 Gew.-% der Fasern (4) parallel zu einer der Orientierungen ausgerichtet sind.

5. Thermoelektrisches Material (1) gemäß einem der Patentansprüche 1 oder 2, wobei die Fasern (4) ungleichmäßig im thermoelektrischen Material (1) verteilt sind.

6. Thermoelektrisches Material (1) gemäß einem der vorhergehenden Patentansprüche, wobei die Fasern (4) mit mindestens einer voneinander verschiedenen Eigenschaft (7) ausgeführt sind, wobei die Eigenschaft (7) eine der folgenden ist: thermische Leitfähigkeit, elektrische Leitfähigkeit, Zugfestigkeit und Dehnbarkeit.

7. Thermoelektrisches Material (1) gemäß einem der vorhergehenden Patentansprüche, wobei die Fasern (4) zumindest mittels Formschluss oder Adhäsion mit dem thermoelektrischen Material (1) verbunden sind.

8. Thermoelektrisches Material (1) gemäß einem der vorhergehenden Patentansprüche, wobei die Fasern (4) zusammen ein Anteil von höchstens 70 Gewichts-% gemessen am Gesamtgewicht des thermoelektrischen Materials (1) haben.

9. Thermoelektrisches Material (1) gemäß einem der vorhergehenden Patentansprüche, wobei die Fasern (4) zumindest teilweise eine Beschichtung (8) aufweisen.

10. Thermoelektrisches Material (1) gemäß einem der vorhergehenden Patentansprüche, wobei die Fasern (4) eine Oberfläche mit einer gemittelten Rautiefe Rz von zumindest 0,5 µm aufweisen.

11. Thermoelektrisches Material (1) gemäß einem der vorhergehenden Patentansprüche, wobei die Fasern (4) eine geringere Wärmeleitfähigkeit als das Halbleitermaterial aufweisen.

12. Verfahren zur Herstellung eines thermoelektrischen Materials (1) mit einer ersten Seite (2) und einer gegenüberliegend angeordneten zweiten Seite (3), wobei das Verfahren zumindest die folgenden Schritte umfasst:
a) Bereitstellen eines pulverförmigen Halbleitermaterials (9),
b) Bereitstellen von Fasern (4), die eine geringere elektrische Leitfähigkeit als das Halbleitermatelial (9) aufweisen,
c) Anordnen der Fasern (4) zusammen mit dem Halbleitermaterial (9) zu einem Ausgangsmaterial (10),
d) Verpressen des Ausgangsmaterials (10);
wobei zumindest 80 Gew.-% der Fasern (4) quer zu zumindest der ersten Seite (2) oder der zweiten Seite (3) ausgerichtet sind.

## Claims

1. Thermoelectric material (1) with a first side (2) and a second side (3) arranged opposite, the thermoelectric material (1) containing fibres (4), at least 80% by weight of the fibres (4) being aligned transversely to at least the first side (2) or the second side (3) and the fibres (4) having a lower electrical conductivity than the semiconductor material (9).

2. Thermoelectric material (1) according to Patent Claim 1, the thermoelectric material (1) being in the form of a ring or a segment of a ring, the first side (2) forming an inner circumferential surface (5) of the thermoelectric material (1) and the second side (3) forming an outer circumferential surface (6) of the thermoelectric material (1).

3. Thermoelectric material (1) according to Patent Claim 1 or 2, at least 80% by weight of the fibres (4) being arranged parallel to one another.

4. Thermoelectric material (1) according to one of the preceding patent claims, fibres (4) being arranged with two or three different orientations in the thermoelectric material (1) and at least 80% by weight of the fibres (4) being aligned parallel to one of the orientations.

5. Thermoelectric material (1) according to either of Patent Claims 1 and 2, the fibres (4) being distributed nonuniformly in the thermoelectric material (1).

6. Thermoelectric material (1) according to one of the preceding patent claims, the fibres (4) being formed with at least one property (7) differing from one another, the property (7) being one of the following: thermal conductivity, electrical conductivity, tensile strength and extensibility.

7. Thermoelectric material (1) according to one of the preceding patent claims, the fibres (4) being joined to the thermoelectric material (1) at least by means of a form-fitting connection or adhesion.

8. Thermoelectric material (1) according to one of the preceding patent claims, the fibres (4) together having a proportion of at most 70% by weight, measured against the total weight of the thermoelectric material (1).

9. Thermoelectric material (1) according to one of the preceding patent claims, the fibres (4) having at least partially a coating (8).

10. Thermoelectric material (1) according to one of the preceding patent claims, the fibres (4) having a surface with a mean roughness Rz of at least 0.5 µm.

11. Thermoelectric material (1) according to one of the preceding patent claims, the fibres (4) having a lower thermal conductivity than the semiconductor material.

12. Method for producing a thermoelectric material (1) with a first side (2) and a second side (3) arranged opposite, the method comprising at least the following steps:
a) providing a pulverulent semiconductor material (9),
b) providing fibres (4), which have a lower electrical conductivity than the semiconductor material (9),
c) arranging the fibres (4) together with the semiconductor material (9) to form a starting material (10),
d) compressing the starting material (10); at least 80% by weight of the fibres (4) being aligned transversely to at least the first side (2) or the second side (3).

## Revendications

1. Matériau thermoélectrique (1) comprenant un premier côté (2) et un deuxième côté (3) disposé à l'opposé, le matériau thermoélectrique (1) contenant des fibres (4), au moins 80 % massiques des fibres (4) étant orientées transversalement au moins par rapport au premier côté (2) ou au deuxième côté (3) et les fibres (4) possédant une conductivité électrique inférieure à celle d'un matériau semiconducteur (9).

2. Matériau thermoélectrique (1) selon la revendication 1, avec lequel le matériau thermoélectrique (1) est en forme d'anneau ou de segments d'anneau, le premier côté (2) formant une surface périphérique intérieure (5) du matériau thermoélectrique (1) et le deuxième côté (3) une surface périphérique extérieure (6) du matériau thermoélectrique (1).

3. Matériau thermoélectrique (1) selon la revendication 1 ou 2, avec lequel au moins 80 % massiques des fibres (4) sont disposées parallèlement les unes aux autres.

4. Matériau thermoélectrique (1) selon l'une des revendications précédentes, avec lequel des fibres (4) ayant deux ou trois orientations différentes sont disposées dans le matériau thermoélectrique (1) et au moins 80 % massiques des fibres (4) sont disposées parallèlement à l'une des orientations.

5. Matériau thermoélectrique (1) selon l'une des revendications 1 ou 2, avec lequel des fibres (4) sont distribuées de manière non uniforme dans le matériau thermoélectrique (1).

6. Matériau thermoélectrique (1) selon l'une des revendications précédentes, avec lequel les fibres (4) sont exécutées avec au moins une propriété (7) différentes entre elles, la propriété (7) étant l'une des suivantes :
conductivité thermique, conductivité électrique, résistance à la traction et extensibilité.

7. Matériau thermoélectrique (1) selon l'une des revendications précédentes, avec lequel les fibres (4) sont reliées au matériau thermoélectrique (1) au moins par complémentarité de formes ou par adhérence.

8. Matériau thermoélectrique (1) selon l'une des revendications précédentes, avec lequel les fibres (4) possèdent ensemble une part maximale de 70 % massiques, mesurée au poids total du matériau thermoélectrique (1).

9. Matériau thermoélectrique (1) selon l'une des revendications précédentes, avec lequel les fibres (4) possèdent au moins partiellement un revêtement (8).

10. Matériau thermoélectrique (1) selon l'une des revendications précédentes, avec lequel les fibres (4) possèdent une surface ayant une profondeur de rugosité moyenne calculée Rz d'au minimum 0,5 µm.

11. Matériau thermoélectrique (1) selon l'une des revendications précédentes, avec lequel les fibres (4) possèdent une conductivité thermique inférieure à celle du matériau semiconducteur.

12. Procédé de production d'un matériau thermoélectrique (1) comprenant un premier côté (2) et un deuxième côté (3) disposé à l'opposé, le procédé comprenant au moins les étapes suivantes :
a) mise à disposition d'un matériau semiconducteur (9) sous forme de poudre,
b) mise à disposition de fibres (4) qui possèdent une conductivité électrique inférieure à celle du matériau semiconducteur (9),
c) arrangement des fibres (4) conjointement avec le matériau semiconducteur (9) en une matière brute (10),
d) compression de la matière brute (10) ;
au moins 80 % massiques des fibres (4) étant orientées transversalement au moins par rapport au premier côté (2) ou au deuxième côté (3)
